# EUROPEAN PATENT APPLICATION

(11) **EP 1 057 656 A1**
(43) Date of publication of application: **06.12.2000**
(21) Application number: 99972582.3
(22) Date of filing: 01.10.1999
(51) Int. Cl.: B42D 15/10, B42D 15/00, B32B 27/36, G06K 19/077

(54) **THREE-LAYER POLYESTER RESIN SHEET FOR CARDS AND POLYESTER RESIN LAMINATES MADE BY USING THE SAME**

(30) Priority: 20.11.1998 JP 33084898; 26.05.1999 JP 14648599
(71) Applicant: UNITIKA LTD., Amagasaki-shi, Hyogo 660-0824 (JP)
(72) Inventor: NAKAYAMA, Yasuki Unitika Ltd., Uji-shi, Kyoto 611-0021 (JP); WAKAMURA, Kazuyuki Unitika Ltd., Uji-shi, Kyoto 611-0021 (JP); OSHITA, Makoto Unitika Ltd., Uji-shi, Kyoto 611-0021 (JP); DOI, Osamu Unitika Ltd., Uji-shi, Kyoto 611-0021 (JP); KOMETANI, Yoshiaki Unitika Ltd., Uji-shi, Kyoto 611-0021 (JP); TSUBOGO, Makoto Unitika Ltd., Uji-shi, Kyoto 611-0021 (JP)
(74) Representative: HOFFMANN - EITLE
(86) International application number: JP9905455
(87) International publication number: WO0030865

(57) **Abstract**

A three layer polyester resin sheet for card use, which comprises a layer of 100 parts by weight of a poly(ethylene terephthalate)-based polyester resin and 50 parts by weight or less of a granular inorganic compound as the intermediate layer and layers of an amorphous polyester resin as both of the outer layers, namely a sheet having excellent surface printability, mechanical strength and heat resistance and also having excellent self-adhesiveness between sheets under a low temperature low pressure condition and embedding ability of electronic parts and the like, and a resin laminate which uses the same.

## Description

### Technical Field

This invention relates to a three layer polyester resin sheet for card use, which is excellent in surface smoothness and low temperature self-adhesiveness and does not pollute the natural environment, and to a polyester resin laminate which uses the same.

### Background Art

Regarding the current plastic cards, magnetic stripe cards in which magnetic stripes are arranged on a surface of card materials, such as bank cash cards, credit cards and various prepaid cards, are commonly used. In recent years, IC module-integrated IC cards have been developed, and some of them have been put into practical use. A generally known and frequently employed case among them is an IC card in which a module composed of an IC memory, a microprocessor, an antenna coil and the like is interposed between base materials comprised of a pair of thermoplastic resin sheets, via an adhesive layer, and they are integrated as such by hot press processing.

As the thermoplastic resin which forms the base materials, amorphous thermoplastic resins such as a polyvinyl chloride resin (to be referred to as "PVC" hereinafter), a vinyl chloride/vinyl acetate copolymer resin (to be referred to as "PVCA" hereinafter) and the like and crystalline thermoplastic polyester resins represented by poly(ethylene terephthalate) (to be referred to as "PET" hereinafter) are used because of their cheapness. Frequently used among them are oriented sheets of poly(ethylene terephthalate)-based polyester resins (to be referred to as "PET-based polyester resin" hereinafter) represented by PET. However, since oriented sheets of the PET-based polyester resin have no mutual adhesiveness under a low temperature low pressure condition which does not ruin electronic parts, when two or more of them are made into a laminate by hot pressing, it is necessary to coat the base material with an epoxy-based adhesive, a polyester-based hot melt adhesive or the like or to use an adhesive layer such as of an amorphous polyester resin sheet, so that there is a problem in that the production process becomes complex and entails increased cost. Also, when they are made into a laminate by hot pressing in combination with different materials, a problem of generating warpage of the laminate occurs depending on the combination. In addition, when used mainly as an IC card, printing is made on a surface of the laminate into which an IC module is inserted, so that good surface printability of the sheet to be used is also required. However, since the oriented sheet of PET-based polyester resin does not have sufficient surface printability, improvements are made for example by applying a corona treatment or a resin coating or the like adhesion facilitation treatment on the sheet surface or newly using a protecting sheet on the printed surface to protect the printed surface. However, this method also has problems in that the cost is increased due to complex production process and stable surface printability cannot be obtained due to the deterioration of adhesion facilitation condition after hot pressing.

In order to solve these problems, a resin sheet in which an amorphous polyester resin was blended with a granular inorganic compound having a specified shape (JP-A-11-1607; the term "JP-A" as used herein means an "unexamined published Japanese patent application") and an IC card in which an amorphous polyester resin sheet having excellent embedding ability was used as an intermediate layer of a pair of resin sheets (JP-A-11-20357) have been proposed, but the former does not have sufficient heat resistance and generates large warpage in some cases depending on its use conditions, and the latter cannot solve the problem of increasing the cost due to complex production process.

On the other hand, a polyester sheet in which a PET-based polyester resin layer was used as the intermediate layer and amorphous polyester resin layers were arranged on its both sides has been proposed (JP-A-5-212840), but this sheet was developed with the aim of improving its heat sealing property as a packaging material having excellent transparency and not suited for applications which require shading property such as the case of IC cards.

The invention contemplates resolving these problems and thereby providing a three layer polyester resin sheet for card use, which has excellent sheet moldability, surface printability, mechanical strength, heat resistance and the like properties and also has excellent self-adhesiveness between sheets under a low temperature low pressure condition and embedding ability of electronic parts and the like, and a polyester resin laminate which uses the same.

### Disclosure of the Invention

With the aim of resolving the above problems, the present inventors have conducted intensive studies and reached the present invention.

Thus, the present invention provides a three layer polyester resin sheet for card use, which comprises a layer of a polyester resin composition comprising 100 parts by weight of a PET-based polyester resin and 50 parts by weight or less of a granular inorganic compound as the intermediate layer and layers of an amorphous polyester resin as both of the outer layers; and a laminate which uses the same.

The following describes the present invention in detail.

In the three layer polyester resin sheet of the invention (to be referred to as "three layer sheet" hereinafter), a layer (A) of a polyester resin composition comprising 100 parts by weight of a PET-based polyester resin and 50 parts by weight or less of a granular inorganic compound is used as the intermediate layer, and a layer (B) of an amorphous polyester resin is used as both of the outer layers.

The PET-based polyester resin which constitutes the layer (A) as the intermediate layer of the invention uses ethylene terephthalate unit as the main repeating unit and contains the ethylene terephthalate unit at a ratio of at least 80 mol% or more, preferably 90 mol% or more, and it preferably has an intrinsic viscosity of preferably from 0.5 to 1.0. The intrinsic viscosity if smaller than 0.5 would reduce mechanical strength of the sheet and if larger than 1.0 would entail inferior sheet moldability.

In this connection, within such a range that it does not spoil characteristics of the invention, the PET-based polyester resin may contain a small amount (generally less than 20 mol%, preferably less than 10 mol%) of a copolymer component, e.g., an aromatic dicarboxylic acid component such as phthalic acid, isophthalic acid, 5-sodium sulfoisophthalic acid, 2,6-naphthalenedicarboxylic acid, 4,4'-diphenyldicarboxylic acid or diphenylsulfondicarboxylic acid, an aromatic polyvalent carboxylic acid component such as trimellitic acid, pyromellitic acid or an acid anhydride thereof, an aliphatic dicarboxylic acid component such as oxalic acid, succinic acid, adipic acid, sebacic acid, azelaic acid or decanedicarboxylic acid, an aliphatic diol component such as 1,2-propanediol, 1,3-propanediol, 1,2-butanediol, 1,3-butanediol, 1,4-butanediol, 2,3-butanediol, diethylene glycol, 1,5-pentanediol, neopentyl glycol, triethylene glycol or poly(ethylene glycol), an aliphatic polyhydric alcohol component such as trimethylolpropane or pentaerythritol, an alicyclic diol component such as 1,4-cyclohexanedimethanol or 1,4-cyclohexanediethanol, or hydroxycarboxylic acid such as 4-hydroxybenzoic acid and ε-caprolactone.

Also, according to the invention, a three layer sheet having excellent mechanical strength, heat resistance, shading property and the like can be obtained by the use, as the intermediate layer, of a layer of a resin composition in which a granular inorganic compound is blended at a ratio of 50 parts by weight or less based on 100 parts by weight of the PET-based polyester resin, but sheet moldability becomes extremely poor when blending amount of the granular inorganic compound exceeds 50 parts by weight, so that it is preferably from 3 to 50 parts by weight, more preferably from 5 to 40 parts by weight.

Though the granular inorganic compound is not particularly limited, its illustrative examples include mica, talc, silica, calcium carbonate, zinc flower, pallasite clay, kaolin, basic magnesium carbonate, quartz powder, titanium dioxide, barium sulfate, calcium sulfate and alumina, of which mica and titanium dioxide can be used particularly preferably.

Also, in order to further improve surface smoothness and shading property of the sheet, it is desirable to use a substance having an average particle size of from 0.2 to 60 µm and an aspect ratio, obtained by dividing the particle size by its thickness, of from 1 to 100, as the granular inorganic compound. The average particle size if smaller than 0.2 µm would not be available and if larger than 60 µm would entail inferior surface smoothness when molded into a sheet. The aspect ratio if smaller than 1 would not be available and if larger than 100 would entail inferior surface smoothness when molded into a sheet.

The layer (B) of an amorphous polyester resin, to be used as both of the outer layers of the invention, is used with the aim of improving self-adhesiveness between a pair of sheets under a low temperature low pressure condition, backside printability and embedding property for electronic parts and/or composite parts thereof (to be referred to as "electronic parts" hereinafter).

The amorphous polyester resin has a heat of fusion of 1 cal/g or less when measured using a differential scanning calorimeter (DSC-7, mfd. by Shimadzu Corp.) at a heating ratio of 20°C/minute in an atmosphere of nitrogen, and has a glass transition point of preferably from 40 to 85°C, more preferably from 55 to 85°C. The glass transition point if lower than 40°C would entail inferior sheet moldability and if higher than 85°C would reduce self-adhesiveness between sheets under a low temperature low pressure condition and embedding property for electronic parts and the like.

Though this amorphous polyester resin can be produced, for example, from a divalent alcohol component and a divalent carboxylic acid component by a direct ester method, ester interchange method or the like known melting condensation polymerization method, it is desirable to adjust its number average molecular weight calculated by the GPC method to 10,000 or more from the viewpoint of mechanical strength and heat resistance of the sheet. Examples of the means for obtaining an amorphous polyester resin having such a molecular weight include a method in which viscosity of a polyester molten material at the time of condensation polymerization is stopped at an appropriate stage and a method in which a monofunctional alcohol or carboxylic acid is added in advance.

Examples of the divalent alcohol component include ethylene glycol, diethylene glycol, triethylene glycol, propylene glycol, 1,4-butanediol, 1,5-pentanediol, 1,6-hexanediol, neopentyl glycol, poly(tetramethylene glycol), poly(ethylene glycol), cyclohexanedimethanol, ethylene oxide addition product of bisphenol A, ethylene oxide addition product of bisphenol S and 2-(9,10-dihydro-9-oxa-10-oxide-phosphaphenanthrene)methylsuccinic acid-bis-(2-hydroxyethyl) ester. These materials are not necessarily used alone, and two or more of them maybe used in their copolymerization. Among them, it is desirable to use ethylene glycol and neopentyl glycol in their coexistence. Also useful are alcohols of trivalent or more, such as trimethylolpropane, pentaerythritol, glycerol and the like.

Examples of the divalent carboxylic acid component include terephthalic acid, isophthalic acid, oxalic acid, malonic acid, succinic acid, adipic acid, itaconic acid, azelaic acid, sebacic acid, eicosanoic diacid, naphthalenedicarboxylic acid, diphenic acid, dodecanoic diacid, cyclohexanedicarboxylic acid and the like. These materials are not necessarily used alone, and two or more of them maybe used in their copolymerization, or their alkyl esters such as dimethyl esters may also be used. Also useful are carboxylic acids of trivalent or more such as trimellitic acid, pyromellitic acid and the like, as well as ε-caprolactone, γ-butyrolactone and the like materials having a ring structure.

Examples of the catalyst which can be used in producing the amorphous polyester resin include antimony trioxide, germanium dioxide, cobalt acetate, zinc acetate, tetrabutyl titanate, dimethyltin maleate, sodium acetate and the like, which may be used alone or as a mixture of two or more. Also, as occasion demands, an antioxidant and the like additives may be added.

Illustrative examples of the amorphous polyester resin of the invention include Elitel (registered trademark) UE-3210, UE-3200 and the like manufactured by UNITIKA. UE-3210 is a copolymer of phthalic acid, isophthalic acid, adipic acid, neopentyl glycol and ethylene glycol, and UE-3200 is a copolymer of terephthalic acid, isophthalic acid, neopentyl glycol and ethylene glycol. Other example is PETG manufactured by Eastman Chemical. PETG is a copolymer of terephthalic acid, cyclohexanedimethanol and ethylene glycol.

Also, according to the invention, it is desirable for further improving shading property to blend the granular inorganic compound at a ratio of 25 parts by weight or less, preferably 15 parts by weight or less, based on 100 parts by weight of the amorphous polyester resin.

In this connection, as occasion demands, the layer (A) of polyester resin composition and/or layer (B) of amorphous polyester resin of the invention can also be blended with various plastic additives such as a heat stabilizer, an oxidation stabilizer, a light stabilizer, a lubricant, a pigment, a plasticizer, a crosslinking agent, an impact resistance improving agent, a flame retarder, a flame resistance assisting agent, an anti-static agent and the like, within such a range that they do not spoil characteristics of the invention.

In producing the three layer sheet of the invention, a commonly known method can be employed. Illustratively, a polyester resin sheet of three layer structure is formed by simultaneously melt-extruding the PET-based polyester resin composition and amorphous polyester resin (or an amorphous polyester resin composition), using a multiple layer sheet forming machine equipped with two or more melt extruders.

In this case, the PET-based polyester resin composition can be supplied to an extruder of the multiple layer sheet forming machine after pelletizing it by a twin screw melt kneader, but it is not necessary to pelletize it in advance when the sheet forming machine is equipped with a melt-kneading function. Also, it is desirable to set temperature of the multiple layer sheet forming machine to about melting point or more of the PET-based polyester resin composition, and is generally set to such a level that the molding can be effected at from 240 to 280°C. In addition, supplying amounts of the PET-based polyester resin composition and amorphous polyester resin (or an amorphous polyester resin composition) are controlled by changing discharge rates of respective extruders.

Weight ratio of both outer layers of the thus obtained three layer sheet is preferably from 5 to 40%, more preferably from 10 to 30%, based on the entire sheet. This ratio if less than 5% would entail inferior embedding ability of electronic parts and the like and if exceeding 40% would entail insufficient mechanical strength of the sheet. Also, weight ratio of the front and back of both outer layers varies depending of the using purpose but is generally adjusted to 1/1 and can also be adjusted within the range of from 3/7 to 7/3. In addition, thickness of the three layer sheet is preferably within the range of from 0.1 to 1.0 mm, from the viewpoint of moldability and surface smoothness, and is preferably within the range of from 0.1 to 0.4 mm particularly for IC card use. The thickness of sheet is controlled by changing discharge rate of the multiple layer sheet forming machine or drawing rate of the sheet.

Next, the polyester resin laminate and electronic part or the like-inserted polyester resin laminate of the invention are described.

Firstly, the polyester resin laminate is a product obtained by laminating from 2 to 20 of the thus prepared three layer sheets.

The electronic part or the like-inserted polyester resin laminate is a product obtained by inserting an electronic part or the like between a pair of sheets prepared in the above manner.

Examples of the electronic parts and the like according to the invention include an IC module (consisting of an IC chip, an antenna, a lead wire and the like), a semiconductor device, a resister, a condenser, a transformer switch, a quartz oscillator, a magnetic head, a connector, a liquid crystal element, a printed wiring board (circuit card), an antenna, a coil, a transformer, a switch, a motor, a switching power source, a miniature battery, a hybrid IC, a lead frame, a flat cable, a slit board and optional combinations thereof, of which IC module is particularly preferable. Also, these electronic parts and the like may be sealed or coated with a resin.

In producing the polyester resin laminate of the invention, a pair of the three layer sheets is stacked firstly and then, while keeping this condition, these layers are integrated by hot press molding using a hot press molding machine.

In this case, the final reaching temperature at the time of the hot press molding is set to a level higher than the glass transition point of the amorphous polyester resin, generally at from 80 to 200°C, preferably from 100 to 170°C. Also, the heating rate is set at generally from 3 to 50°C/min, preferably from 5 to 10°C/min. Also, the pressing maximum pressure is set to generally from 0.5 to 60 MPa, preferably from 1 to 50 MPa, taking self-adhesiveness between the sheets into consideration. In addition, retention time of the hot press molding is set to generally 30 minutes or less, preferably from 15 to 25 minutes.

In producing the electronic part or the like-inserted polyester resin laminate of the invention, an electronic part or the like is interposed between a pair of the three layer sheets firstly and then, while keeping this condition, they are integrated by hot press molding using a hot press molding machine.

In this case, the final reaching temperature at the time of the hot press molding is set to a level higher than the glass transition point of the amorphous polyester resin similar to the condition for producing the polyester resin laminate, but a level which does not cause thermal damage to the inserted electronic part or the like, namely generally at from 80 to 150°C, preferably from 100 to 130°C. Also, the heating rate is set at generally from 3 to 50°C/min, preferably from 5 to 10°C/min. Also, the pressing maximum pressure is set to generally from 0.5 to 5 MPa, preferably from 1 to 3 MPa, taking a balance of self-adhesiveness between the sheets and pressure damage of the electronic part or the like into consideration. In addition, retention time of the hot press molding is set to generally 20 minutes or less, preferably from 5 to 15 minutes.

### Best Mode for Carrying Out the Invention

Next, the invention is described more illustratively with reference to Examples.

In this connection, various characteristic values in the Examples and Comparative Examples are evaluated as follows.

### (a) Sheet moldability

Evaluated by the following two steps depending on the conditions when a sheet was molded.
○: It was able to produced the sheet satisfactorily.
X: It was unable to produce satisfactorily due to sheet breakage or generation of holes in the sheet.

### (b) Self-adhesiveness

Adhesion strength was observed by gently inserting a cutter blade between the laminate-constituting sheets, and the result was evaluated by the following two steps.
○: Pealing was not generated.
X: Pealing was generated partly or over the entire area.

### (c) Conditions of IC chip

Using equivalent weight mixture of phenol and tetrachloroethane as the solvent, a laminate sample was soaked therein for 1 hour at 100°C to dissolve its resin components and then the surface of IC chip was observed under a stereoscope to evaluate its conditions by the following two steps.
○: Abnormality was not found on the surface.
X: Cracks were formed on the surface, or it was deformed.

### (d) Embedding ability

Using a surface roughness meter (SurfTest 201, mfd. by Mitsutoyo), a ten point average roughness Rz on the surface of a laminate was measured at a measuring distance of 12.5 mm, and embedding ability of IC module was evaluated based on the measured value by the following two steps.
○: The Rz value was less than 15 µm.
X: The Rz value was 15 µm or more.

### (e) Tensile strength and tensile modulus of elasticity

Tensile strength and tensile modulus of elasticity of each laminate were measured in accordance with the method described in ASTM-D638.

### (f) Shading property

Using a spectral color-difference/turbidity meter (SZ-Σ90 COLOR MEASURING SYSTEM, mfd. by Nippon Denshoku Kogyo), shading property of each laminate was examined by total light transmittance measurement, and the shading property was evaluated by the following two stages.
○: The total light transmittance was less than 10%.
X: The total light transmittance was 10% or more.

### (g) Printability

A surface of each laminate was printed using Celicol UV-FIL manufactured by Teikoku Ink. The printing was carried out using a Tetron (registered trademark) screen plate (T-420 mesh), and hardening was effected by carrying out 3 seconds of irradiation with a metal hydrolamp 80W/cm manufactured by Ushio Inc. from a distance of 15 cm.

An adhesive tape (cellophane tape) was adhered to the thus printed surface and then peeled off to observe adhesion of the ink to the adhesive tape, namely peeling of the ink from the laminate, and the printability was evaluated by the following two steps.
○: Completely no peeling of the ink.
X: Peeling of the ink was found even partly.

### Example 1

Pellets of a polyester resin composition which constitutes the layer (A) as the intermediate layer of the tree layer sheet were prepared in the following manner.

Using a twin screw melt kneader (TEM-70, mfd. by Toshiba Machine), pellets were prepared at a blending ratio of 100 parts by weight of PET (SA-3215P, mfd. by Unitika) having an intrinsic viscosity of 0.78 as the PET-based polyester resin, 17 parts by weight of mica (M-400, mfd. by Repco) having an average particle size of 13 µm and an aspect ratio of 25 and 8 parts by weight of titanium dioxide (2G-9659, mfd. by Nippon Pigment) having an average particle size of 0.2 µm as the granular inorganic compounds, and 0.2 part by weight of an antioxidant (Irganox 1010, mfd. by Ciba-Geigy). Production conditions by the twin screw melt kneader were temperature 250 to 280°C, discharge rate 150 kg/h and screw L/D = 28.

Also, PETG 6763 pellets (mfd. by Eastman Chemical) were used as the amorphous polyester resin which constitutes the layer (B) as both of the outer layers of the three layer sheet.

These two types of pellets were separately supplied to a multiple layer sheet forming machine equipped with three extruders, and a three layer sheet having a thickness of 0.25 mm was prepared by extruding the layer (B) which constitutes both of the outer layers, in a sheet form on both sides of the layer (A), in such a manner that both of the outer layers have the same thickness and their weight ratio becomes 20% of the entire sheet. In this case, production conditions by the multiple layer sheet forming machine were temperature 250 to 280°C, discharge rate 100 kg/h and screw L/D = 25, and 0.03% of calcium stearate was added as a lubricant to the pellets of the intermediate layer-forming polyester-based resin composition. Construction and characteristics of the thus obtained three layer sheet are shown in Table 1.

An IC module having an IC chip of 0.2 mm in thickness was arranged between a pair of the three layer sheets prepared above and, under such a condition and using a hot press molding machine, they were heated from ordinary temperature to 130°C at a heating rate of 10°C/min, kept at 130°C for 10 minutes and then quickly cooled to ordinary temperature. The pressure was kept under 0.1 MPa until 70°C, gradually increased to 2 MPa between 70 to 90°C and then kept under 2 MPa until completion of the cooling.

By the above method, a laminate having an average thickness of 0.45 mm was obtained.

In this case, when the hot press molding machine was operated, an aluminum alloy mat plate having a ten point average roughness Rz of 6 µm was used as the press plate. Characteristics of the thus obtained laminate are shown in Table 1.

### Examples 2 and 3

Pellets were prepared in such a manner that constructions of the layer (A) as the intermediate layer of respective three layer sheets became those shown in Table 1. By fixing other conditions as described in Example 1, three layer sheets and laminates were prepared. Constructions and characteristics of the thus obtained three layer sheets and characteristics of the laminates are shown in Table 1.

### Examples 4 and 5

Three layer sheets and laminates were prepared in the same manner as described in Example 1, except that respective weight ratios of the layer (B) as both outer layers of the three layer sheets were changed as shown in Table 1. Constructions and characteristics of the thus obtained three layer sheets and characteristics of the laminates are shown in Table 1.

### Examples 6 and 7

As the layer (B) as both outer layers of the three layer sheets, Elitel UE-3210 (mfd. by UNITIKA) was used in Example 6, and Elitel UE-3200 (mfd. by UNITIKA) in Example 7. By fixing other conditions as described in Example 1, three layer sheets and laminates were prepared. Constructions and characteristics of the thus obtained three layer sheets and characteristics of the laminates are shown in Table 1.

**Table 1**

| | | Unit | Example | | | | | | |
|---|---|---|---|---|---|---|---|---|---|
| | | | 1 | 2 | 3 | 4 | 5 | 6 | 7 |
| | | | | | | | | | |

| Three layer sheet Construction | | | | | | | | | |
|---|---|---|---|---|---|---|---|---|---|
| Intermediate layer | PET | wt. part | 100 | 100 | 100 | 100 | 100 | 100 | 100 |
| | Mica | wt. part | 17 | 5 | 40 | 17 | 17 | 17 | 17 |
| | TiO₂ | wt. part | 8 | 8 | 8 | 8 | 8 | 8 | 8 |
| Both outer layers | Outer layer resin | - | PETG 6763 | PETG 6763 | PETG 6763 | PETG 6763 | PETG 6763 | Elitel UE-3210 | Elitel UE-3200 |
| Ratio of both outer layers | | % | 20 | 20 | 20 | 10 | 30 | 20 | 20 |

| Characteristics | | | | | | | | | |
|---|---|---|---|---|---|---|---|---|---|
| Sheet moldability | | - | ○ | ○ | ○ | ○ | ○ | ○ | ○ |

| Laminate | | | | | | | | | |
|---|---|---|---|---|---|---|---|---|---|
| Characteristics | | | | | | | | | |
| Self-adhesiveness | | - | ○ | ○ | ○ | ○ | ○ | ○ | ○ |
| IC chip condition | | - | ○ | ○ | ○ | ○ | ○ | ○ | ○ |
| Embedding ability | | - | ○ | ○ | ○ | ○ | ○ | ○ | ○ |
| Tensile strength | | MPa | 65 | 63 | 66 | 65 | 61 | 65 | 64 |
| Tensile modulus of elasticity | | MPa | 4300 | 3300 | 5400 | 5400 | 3100 | 4200 | 4100 |
| Shading property | | - | ○ | ○ | ○ | ○ | ○ | ○ | ○ |
| Printability | | - | ○ | ○ | ○ | ○ | ○ | ○ | ○ |

In Examples 1 to 7, a polyester resin composition in which blending ratio of the granular inorganic compounds (mica and titanium dioxide) to the PET resin is within the range of the invention was used in the layer (A) as the intermediate layer of the three layer sheet, an amorphous polyester resin was used in the layer (B) as both of the outer layers of the three layer sheet and weight ratio of both outer layers was set within the preferred range of the invention, so that the sheet moldability was good, and various characteristics of the laminates obtained by hot pressing were also good. That is, adhesiveness between the laminate-constituting sheets was good, the IC module was properly embedded in the laminate, tensile strength, tensile modulus of elasticity and shading ability were sufficient and printability on the laminate surface was also good.

### Examples 8 to 10

Pellets of a polyester resin composition which constitutes the layer (A) as the intermediate layer of the tree layer sheet were prepared in the following manner.

Using a twin screw melt kneader, pellets were prepared in the same manner as described in Example 1, at a blending ratio of 100 parts by weight of PET (SA-3215P, mfd. by Unitika) having an intrinsic viscosity of 0.78 as the PET-based polyester resin, 17 parts by weight of mica (M-400, mfd. by Repco) having an average particle size of 13 µm and an aspect ratio of 25 as the granular inorganic compound and 0.2 part by weight of an antioxidant (Irganox 1010, mfd. by Ciba-Geigy).

Also, similar to the case of Example 1, an amorphous polyester resin PETG 6763 was used in the layer (B) as both of the outer layers of the three layer sheet to produce a three layer sheet having a thickness of 0.25 mm.

Using a pair of the thus obtained three layer sheet, a laminate was obtained in the same manner as described in Example 1. Construction of the thus obtained three layer sheet and characteristics of the laminate are shown in Table 2.

### Examples 11 to 13

Pellets of a polyester resin composition which constitutes the layer (A) as the intermediate layer of the tree layer sheet were prepared in the following manner.

Using a twin screw melt kneader, pellets were prepared in the same manner as described in Example 1, at a blending ratio of 100 parts by weight of PET (SA-3215P, mfd. by Unitika) having an intrinsic viscosity of 0.78 as the PET-based polyester resin, 8 parts by weight of titanium dioxide (2G-9659, mfd. by Nippon Pigment) having an average particle size of 0.2 µm as the granular inorganic compound and 0.2 part by weight of an antioxidant (Irganox 1010, mfd. by Ciba-Geigy).

Thereafter, a three layer sheet having a thickness of 0.25 mm was prepared by the same method of Example 1.

Using a pair of the thus obtained three layer sheet, a laminate was obtained in the same manner as described in Example 1. Construction of the thus obtained three layer sheet and characteristics of the laminate are shown in Table 2.

### Comparative Example 1

Pellets were prepared in such a manner that the layer (A) as the intermediate layer of the three layer sheet had the construction shown in Table 2. Thereafter, an attempt was made to prepare a sheet in the same manner as described in Example 1, but the sheet moldability was poor because of the frequent generation of sheet breakage. Construction and characteristics of the thus obtained three layer sheet are shown in Table 2.

### Comparative Example 2

Regarding the layer (B) of both outer layers of the three layer sheet, a PET resin as a crystalline polyester resin (SA-3215P, mfd. by UNITIKA) was used instead of an amorphous polyester resin. By fixing other conditions, a sheet was prepared in the same manner as described in Example 1. Construction and characteristics of the thus obtained three layer sheets and a part of the characteristics of the laminate are shown in Table 2.

**Table 2**

| | | Unit | Example | | | | | | Comparative Example | |
|---|---|---|---|---|---|---|---|---|---|---|
| | | | 8 | 9 | 10 | 11 | 12 | 13 | 1 | 2 |
| | | | | | | | | | | |

| Three layer sheet Construction | | | | | | | | | | |
|---|---|---|---|---|---|---|---|---|---|---|
| Intermediate layer | PET | wt. part | 100 | 100 | 100 | 100 | 100 | 100 | 100 | 100 |
| | Mica | wt. part | 17 | 17 | 17 | 0 | 0 | 0 | 60 | 17 |
| | TiO₂ | wt. part | 0 | 0 | 0 | 8 | 8 | 8 | 8 | 8 |
| Both outer layers | Outer layer resin | - | PETG 6763 | PETG 6763 | PETG 6763 | PETG 6763 | PETG 6763 | PETG 6763 | PETG 6763 | SA-3215P |
| Ratio of both outer layers | | % | 20 | 10 | 30 | 20 | 10 | 30 | 20 | 20 |

| Characteristics | | | | | | | | | | |
|---|---|---|---|---|---|---|---|---|---|---|
| Sheet moldability | | - | ○ | ○ | ○ | ○ | ○ | ○ | X | ○ |

| Laminate Characteristics | | | | | | | | | | |
|---|---|---|---|---|---|---|---|---|---|---|
| Self-adhesiveness | | - | ○ | ○ | ○ | ○ | ○ | ○ | - | X |
| IC chip condition | | - | ○ | ○ | ○ | ○ | ○ | ○ | - | ○ |
| Embedding ability | | - | ○ | ○ | ○ | ○ | ○ | ○ | - | - |
| Tensile strength | | MPa | 66 | 66 | 63 | 65 | 63 | 66 | - | - |
| Tensile modulus of elasticity | | MPa | 4300 | 4500 | 3400 | 4300 | 3300 | 5400 | - | - |
| Shading property | | - | ○ | ○ | ○ | ○ | ○ | ○ | - | - |
| Printability | | - | ○ | ○ | ○ | ○ | ○ | ○ | - | - |

In Examples 8 to 13, a polyester resin composition in which blending ratio of the granular inorganic compound (mica or titanium dioxide) to the PET resin is within the range of the invention was used in the layer (A) as the intermediate layer of the three layer sheet, an amorphous polyester resin was used in the layer (B) as both of the outer layers of the three layer sheet and weight ratio of both outer layers was set within the preferred range of the invention, so that the sheet moldability was good, and various characteristics of the laminates obtained by hot pressing were also good. That is, adhesiveness between the laminate-constituting sheets was good, the IC module was properly embedded in the laminate, tensile strength, tensile modulus of elasticity and shading ability were sufficient and printability on the laminate surface was also good.

Regarding Comparative Example 1, it was unable to prepare a laminate due to poor sheet moldability.

Regarding Comparative Example 2, a PET resin as a crystalline polyester resin was used in both outer layers, so that it was unable to prepare a proper laminate due to generation of peeling between the sheets at the time of the preparation of laminate.

### Examples 14 to 16

Pellets of a polyester resin composition which constitutes the layer (A) as the intermediate layer of the tree layer sheet were prepared in the following manner.

Using a twin screw melt kneader, pellets were prepared in the same manner as described in Example 1, at a blending ratio of 100 parts by weight of PET (SA-3215P, mfd. by Unitika) having an intrinsic viscosity of 0.78 as the PET-based polyester resin, 17 parts by weight of mica (M-400, mfd. by Repco) having an average particle size of 13 µm and an aspect ratio of 25 and 6 parts by weight of titanium dioxide (2G-9659, mfd. by Nippon Pigment) having an average particle size of 0.2 µm as the granular inorganic compounds, and 0.2 part by weight of an antioxidant (Irganox 1010, mfd. by Ciba-Geigy).

Also, for use in the layer (B) as both of the outer layers of the three layer sheet, pellets were prepared using a twin screw melt kneader (TEM-70, mfd. by Toshiba Machine) by blending 100 parts by weight of PETG 6763 as an amorphous polyester resin with 5 parts by weight of titanium dioxide (2G-9659, mfd. by Nippon Pigment) having an average particle size of 0.2 µm. Production conditions by the twin screw melt kneader were temperature 250 to 280°C, discharge rate 100 kg/h and screw L/D = 28.

Using the thus obtained pellets, a three layer sheet having a thickness of 0.25 mm was prepared in the same manner as described in Example 1.

Using a pair of the thus obtained three layer sheet, a laminate was prepared in the same manner as described in Example 1. Construction and physical properties of the thus obtained three layer sheet and characteristics of the laminate are shown in Table 3.

### Comparative Example 3

Pellets were prepared in such a manner that the layer (A) as the intermediate layer of the three layer sheet and the layer (B) as its both outer layers had the constructions shown in Table 3. Thereafter, an attempt was made to prepare a sheet in the same manner as described in Example 1, but the sheet moldability was poor because of the frequent generation of sheet breakage. Construction and characteristics of the thus obtained three layer sheet are shown in Table 3.

### Comparative Example 4

Regarding the layer (B) of both outer layers of the three layer sheet, a PET resin as a crystalline polyester resin (SA-3215P, mfd. by UNITIKA) was used instead of an amorphous polyester resin. By fixing other conditions, a three layer sheet and a laminate were prepared in the same manner as described in Example 14. Construction and characteristics of the thus obtained three layer sheets and characteristics of the laminate are shown in Table 3.

**Table 3**

| | | Unit | Example | | | Comparative Example | |
|---|---|---|---|---|---|---|---|
| | | | 14 | 15 | 16 | 3 | 4 |
| | | | | | | | |

| Three layer sheet Construction | | | | | | | |
|---|---|---|---|---|---|---|---|
| Intermediate layer | PET | wt. part | 100 | 100 | 100 | 100 | 100 |
| | Mica | wt. part | 17 | 17 | 17 | 60 | 17 |
| | TiO₂ | wt. part | 6 | 6 | 6 | 6 | 6 |
| Both outer layers | Outer layer resin | - | PETG 6763 | PETG 6763 | PETG 6763 | PETG 6763 | SA-3215P |
| | TiO₂ | wt. part | 5 | 5 | 5 | 5 | 5 |
| Ratio of both outer layers | | % | 20 | 10 | 30 | 20 | 20 |

| Characteristics | | | | | | | |
|---|---|---|---|---|---|---|---|
| Sheet moldability | | - | ○ | ○ | ○ | X | ○ |

| Laminate Characteristics | | | | | | | |
|---|---|---|---|---|---|---|---|
| Self-adhesiveness | | - | ○ | ○ | ○ | - | X |
| IC chip condition | | - | ○ | ○ | ○ | - | ○ |
| Embedding ability | | - | ○ | ○ | ○ | - | - |
| Tensile strength | | MPa | 63 | 65 | 60 | - | - |
| Tensile modulus of elasticity | | MPa | 4500 | 4500 | 3400 | - | - |
| Shading property | | - | ○ | ○ | ○ | - | - |
| Printability | | - | ○ | ○ | ○ | - | - |

In Examples 14 to 16, a polyester resin composition in which blending ratio of the granular inorganic compounds (mica and titanium dioxide) to the PET resin is within the range of the invention was used in the layer (A) as the intermediate layer of the three layer sheet, a resin composition in which blending ratio of the granular inorganic compound (titanium dioxide) to the amorphous polyester resin is within the preferred range of the invention was used in the layer (B) as both of the outer layers of the three layer sheet and weight ratio of both outer layers was set within the preferred range of the invention, so that the sheet moldability was good, and various characteristics of the laminates obtained by hot pressing were also good. That is, adhesiveness between the laminate-constituting sheets was good, the IC module was properly embedded in the laminate, tensile strength, tensile modulus of elasticity and shading ability of the laminates were sufficient and printability on the laminate surface was also good.

Regarding Comparative Example 3, it was unable to prepare a laminate due to poor sheet moldability.

Also, regarding Comparative Example 4, a PET resin as a crystalline polyester resin was used in both outer layers, so that it was unable to obtain a proper laminate due to generation of peeling between the sheets at the time of the preparation of laminate.

### Industrial Applicability

Since the layer (B) of an amorphous polyester resin as both outer layers of the three layer sheet exerts its effect as an adhesive layer in the thus obtained laminate, press molding under low temperature low pressure condition becomes possible and excellent electronic part or the like-embedding ability and surface smoothness can be obtained.

In addition, since the intermediate layer of the three layer sheet comprises the layer (A) of a PET-based polyester resin composition which contains a specified amount of a granular inorganic compound, mechanical strength, heat resistance and the like become excellent. In consequence, in producing an electronic part or the like-integrated polyester laminate, not only the conventionally employed methods, (1) formation of an embedding part for integrating an electronic part or the like into the sheet, (2) arrangement of an additional adhesive or binder layer and (3) use of a reinforcing sheet, are unnecessary but also such an electronic part or the like-integrated polyester laminate can be produced easily with a low cost.

## Claims

1. A three layer polyester resin sheet for card use, which comprises a layer (A) of a polyester resin composition comprising 100 parts by weight of a poly(ethylene terephthalate)-based polyester resin and 50 parts by weight or less of a granular inorganic compound as an intermediate layer and layers (B) of an amorphous polyester resin as both of the outer layers.

2. The three layer polyester resin sheet for card use according to claim 1, wherein the layer (B) of an amorphous polyester resin comprises 100 parts by weight of an amorphous polyester resin and 25 parts by weight or less of a granular inorganic compound.

3. The three layer polyester resin sheet for card use according to claim 1 or 2, wherein weight ratio of both of the outer layers is from 5 to 40% of the entire sheet.

4. A polyester resin laminate which uses from 2 to 20 sheets of the polyester resin sheet for card use described in claim 1 or 2.

5. A polyester resin laminate which comprises an electronic part and/or a composite part thereof inserted between a pair of the three layer polyester resin sheet for card use described in claim 1 or 2.
